# EUROPEAN PATENT APPLICATION

(11) **EP 4 589 184 A1**
(43) Date of publication of application: **23.07.2025**
(21) Application number: 25152006.0
(22) Date of filing: 15.01.2025
(51) Int. Cl.: F16L 3/01, F16L 27/00, F16L 27/10, F16L 27/12, F16L 3/18, F16L 3/205, F16L 37/50

(54) **CONNECTOR**

(30) Priority: 19.01.2024 CN 202410084643
(71) Applicant: Southco Manufacturing and Technology (Shenzhen) Co., Ltd., Shenzhen 518103 (CN)
(72) Inventor: PENG, Jingyao, Shenzhen 518103 (CN)
(74) Representative: Winter, Brandl - Partnerschaft mbB

(57) **Abstract**

The present disclosure discloses a connector (100). The connecter (100) includes a housing (110); a pipe (120) at least partially disposed in the housing (110); and a base (160) mounted to a first item and disposed to the housing (110) to allow the housing (110) to float between a first longitudinal position and a second longitudinal position relative to the base (160), such that the pipe (120) is connected to a second item in a floating manner along the longitudinal direction.

## Description

### TECHNICAL FIELD

The present disclosure relates to a connector, in particular to a floating connector.

### BACKGROUND

Connectors are conventional devices. In an application environment such as a server, it is necessary to provide a connector to guide cooling liquid from an outlet pipe (for example, a cooling liquid source) to an inlet pipe (for example, inside the server). In some cases, a connection of pipes for the cooling liquid is not permanent, but temporary. That is, the connector may be switched between different servers, i.e., it may be connected to one server for a period of use and connected to another server for another period of time.

Thus, on the one hand, it is expected to have a function of quick connection between the connector and the server, so as to allow convenient and quick switching between connection modes. Moreover, it is expected that the connector has a floating connection function, which can ensure the alignment between the connector and the inlet pipe when there is a certain error between the installation environment of the connector and the inlet pipe. On the other hand, it is also expected that the connector can provide force feedback function in a connection direction, so that users can know whether the connection is completed, thereby avoiding unstable connection.

### SUMMARY

A connector according to the present disclosure includes: a housing; a pipe at least partially disposed in the housing; and a base mounted to a first item and disposed to the housing to allow the housing to float between a first longitudinal position and a second longitudinal position relative to the base, such that the pipe is connected to a second item in a floating manner along the longitudinal direction.

In an embodiment, the connector further includes an indicator provided on the base (160) and configured to send an indication signal when the housing is disengaged from the second longitudinal position.

In an embodiment, the indicator includes a switch. The switch is in a triggered state when the housing is in the second longitudinal position, such that the switch does not send the indication signal. The switch is in a non-triggered state and sends the indication signal when the housing is disengaged from the second longitudinal position.

In an embodiment, the indicator further includes a plate portion disposed in the base. The switch abuts against the housing and retracts into the plate portion when the switch is in the triggered state, and the switch extends from the plate portion when the switch is in the non-triggered state.

In an embodiment, the connector further includes a first floating spring disposed between the base and the housing, and biasing the housing towards the second longitudinal position relative to the base.

In an embodiment, an outer surface of the housing is provided with a recessed portion, and the housing is provided with a first end wall and a second end wall that are opposite to each other along the longitudinal direction. The base is disposed in the recessed portion, and the first end wall and the second end wall respectively abut against the base to define the first longitudinal position and the second longitudinal position of the housing.

In an embodiment, the base includes at least one sliding portion provided in the recessed portion, and each of the at least one sliding part is provided with a first spring slot for accommodating the first floating spring. One end of the first floating spring abuts against the first end wall, and the other end of the first floating spring abuts in the first spring slot.

In an embodiment, each of the at least one sliding portion is provided with at least one sliding groove extending along the longitudinal direction. The connector includes at least one pin fixed to the housing, and the pin extends laterally and is inserted into the sliding groove to guide a longitudinal movement of the housing.

In an embodiment, the base includes: a pair of sliding parts laterally on both sides of the housing; and a bridge portion connected between the sliding parts. The sliding portions and the bridge portion do not exceed an extension range of the housing on a plane perpendicular to the longitudinal direction.

In an embodiment, the housing includes an accommodation space extending along the longitudinal direction, and the pipe is accommodated in the accommodation space and is floatable relative to the housing along a lateral direction and a vertical direction.

In an embodiment, the connector further includes a plurality of second floating springs arranged between an inner wall of the housing and an outer wall of the pipe along the lateral direction and the vertical direction, so as to allow a lateral floating, a vertical floating or a tilting floating of the pipe.

In an embodiment, the base is provided outside the accommodation space.

### BRIEF DESCRIPTION OF THE DRAWINGS

FIGS. 1A to 1F are a front view, a rear view, a left view, a right view, a top view and a bottom view, respectively, of a connector according to the present disclosure; FIGS. 1G to 1H are perspective views of the connector from different angles, respectively.
FIG. 2 is an exploded perspective view of the connector.
FIGS. 3A and 3B are perspective views of the connector from different angles, respectively, in which the housing is shown in a first longitudinal position relative to a base.
FIGS. 4A and 4B are perspective views of the connector from different angles, respectively, in which the housing is shown in a second longitudinal position relative to the base.
FIG. 5A is a perspective view of a first housing of the connector.
FIG. 5B is a perspective view of a second housing of the connector.
FIG. 6 is a perspective view of a pipe of the connector.
FIG. 7 is a perspective view of the base of the connector.
FIG. 8 is a perspective view of a trigger of the connector.
FIGS. 9A and 9B are perspective views of the connector, respectively, with a part of the housing removed to show an internal structure thereof.
FIG. 10 is a cross-sectional view taken along line A-A in FIG. 1F.

### List of reference numbers:

100 Connector
110 Housing
   110a First Housing
110b Second Housing
   111 Accommodation Space
   112 Bonding Portion
   113 First End Wall
   114 Second End Wall
   115 Limit Portion
   116 Second Spring Slot
   117 Recessed Portion
   118 Hole
120 Pipe
   121 First End
   122 Second End
   123 Intermediate Section
   124 First Flange
      124a Alignment Portion
   125 Second Flange
140 Gasket
150 Clamping Ring
160 Base
   161 Sliding Portion
   162 Bridge Portion
   163 Sliding Groove
   164 First Spring Slot
170 Indicator
   171 Plate Portion
   172 Switch
   173 Signal Line
191 First Floating Spring
192 Second Floating Spring
193 Pin
194 Bolt

### DETAILED DESCRIPTION

Although the present disclosure is illustrated and described herein with reference to specific embodiments, the present disclosure should not be limited to the details shown. Rather, various modifications may be made to these details within the scope of equivalents of the claims without departing from the present disclosure.

The descriptions of directions such as "front", "rear", "upper" and "lower" herein are only intended for the convenience of understanding, and the present disclosure is not limited to these directions, but may be adjusted according to the actual situations.

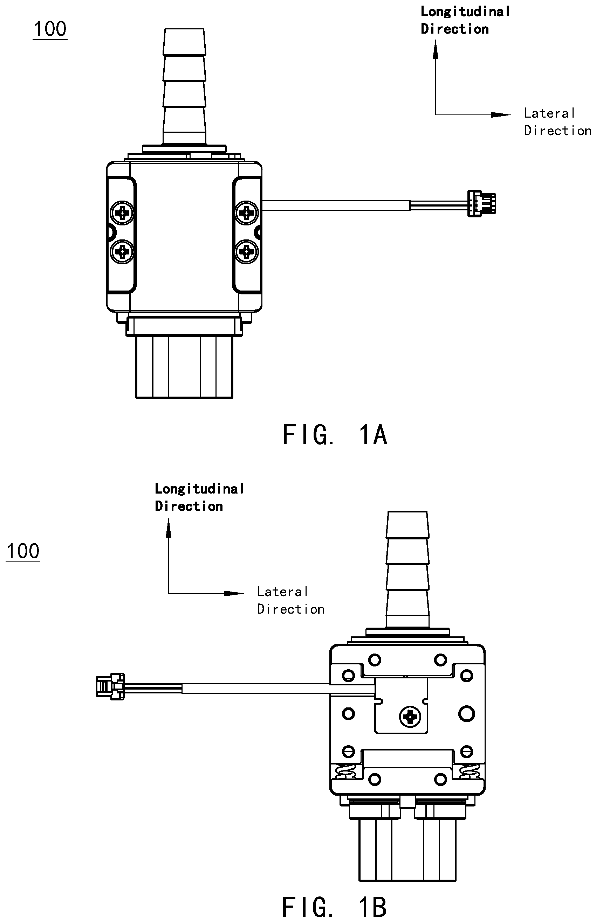

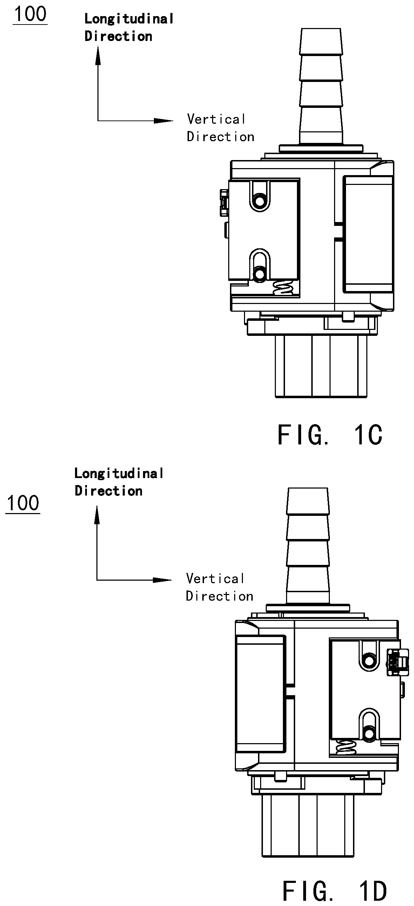

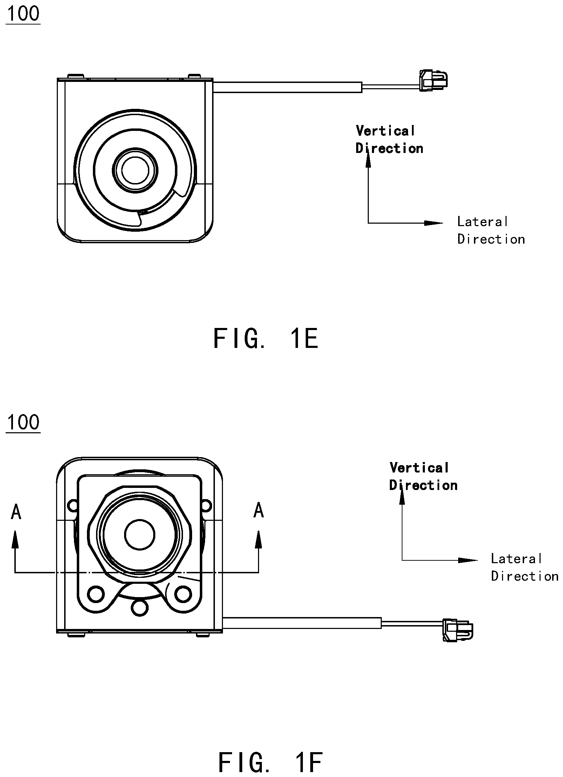

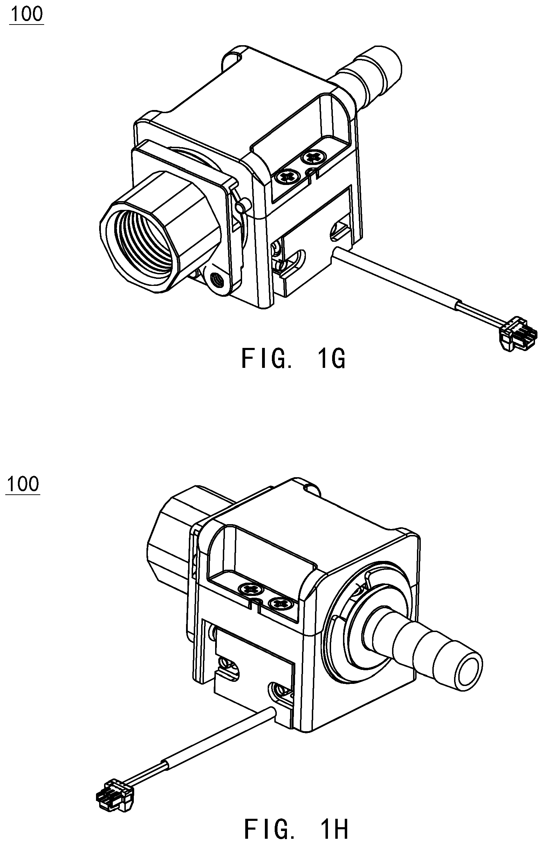

A connector 100 according to the present disclosure is described as a whole with reference to FIGS. 1A to 2. The connector 100 includes a housing 110, a pipe 120, a gasket 140, a clamping ring 150, a base 160, an indicator 170, a first floating spring 191, a second floating spring 192, a pin 193 and a bolt 194.

The base 160 is mounted to a first item such as a circuit board. The first item is mounted to a second item, such as a chassis, by other connection methods not shown in the present disclosure (for example, by bolting, plugging, welding, etc.). One end of the pipe 120 is connected to a fluid pipe (not shown), and the other end of the pipe 120 is connected to a joint (not shown) provided on the second item. Since there may be manufacturing tolerance or installation tolerance between the first item and the second item, it is necessary to connect the pipe 120 to a joint of the second item in a floating manner.

The connector 100 of the present disclosure is designed to realize the floating function in the longitudinal direction, the lateral direction and the vertical direction. The longitudinal direction is an extending direction of the pipe 120, and the lateral direction and the vertical direction are approximately perpendicular to the longitudinal direction. The longitudinal direction, the lateral direction and the vertical direction are defined only for convenience of understanding, and do not limit a mounting direction of the connector 100 of the present disclosure, and it is not necessary to define the longitudinal direction, the lateral direction and the vertical direction to be strictly perpendicular to each other.

In this embodiment, a plurality of gaskets 140 are respectively sleeved on the pipe 120 and disposed at both ends of the housing 110, preventing the pipe 120 from being inclined relative to the housing 110. A clamping ring 150 is provided at at least one end of the pipe 120 to prevent the pipe 120 from being disengaged from the housing 110.

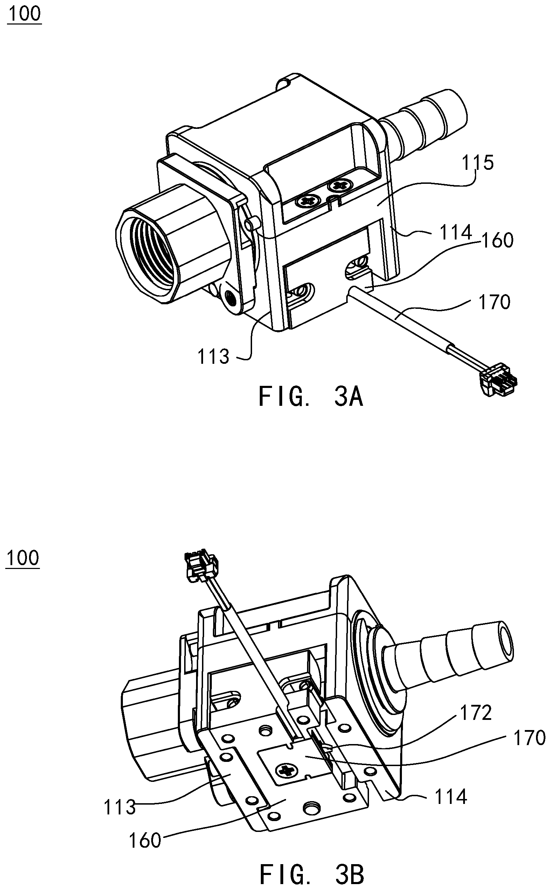

The floating connection between the base 160 and the housing 110 is generally described with reference to FIGS. 3A to 4B.

The base 160 is fixedly disposed on the first item (not shown), and the housing 110 may be disposed on the base 160 in a floating manner along the longitudinal direction. For example, the base 160 may be embedded in the housing 110 to reduce the overall size of the connector 100. However, this is not necessary, and the base 160 may be disposed outside the housing 110, or may have a size larger than that of the housing 110 and accommodate the housing 110.

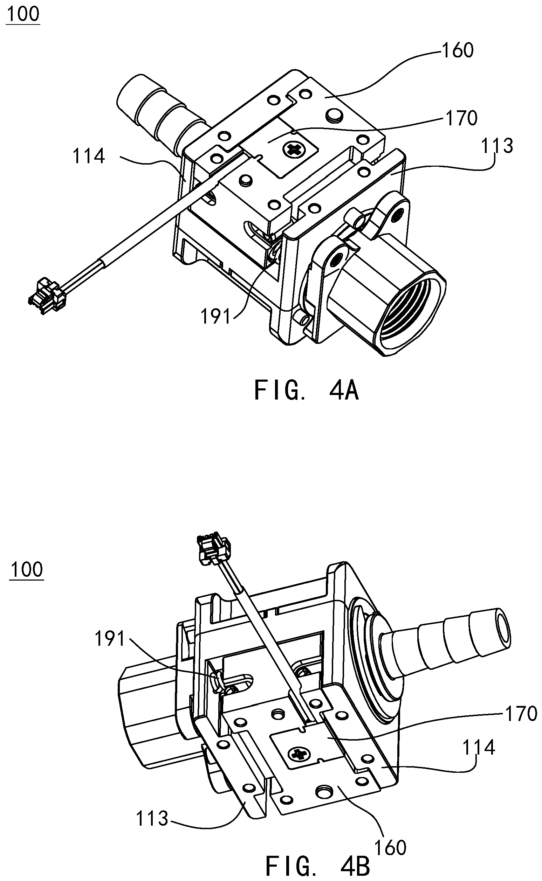

The housing 110 is floatable between a first longitudinal position and a second longitudinal position relative to the base 160. FIGS. 3A and 3B show the housing 110 in the first longitudinal position, and at this time, a first end wall 113 of the housing 110 abuts against the base 160. FIGS. 4A and 4B show the housing 110 in the second longitudinal position, and at this time, a second end wall 114 of the housing 110 abuts against the base 160.

The first floating spring 191 is disposed between the housing 110 and the base 160 to realize the longitudinal floating. More specifically, the first floating spring 191 biases the housing 110 towards the second longitudinal position shown in FIGS. 4A and 4B relative to the base 160. Thus, when the pipe 120 is not connected to the second item, the housing 110 (and the pipe 120 accommodated in the housing 110) is held in the second longitudinal position by the first floating spring 191. When the pipe 120 is connected to the second item and there is a tolerance between the first item and the second item, the housing 110 and the pipe 120 are floatable along the longitudinal direction to be disengaged from the second longitudinal position. The first longitudinal position is a maximum longitudinal floating position of the housing 110 and the pipe 120, and thus a distance between the first longitudinal position and the second longitudinal position is a maximum longitudinal floating stroke.

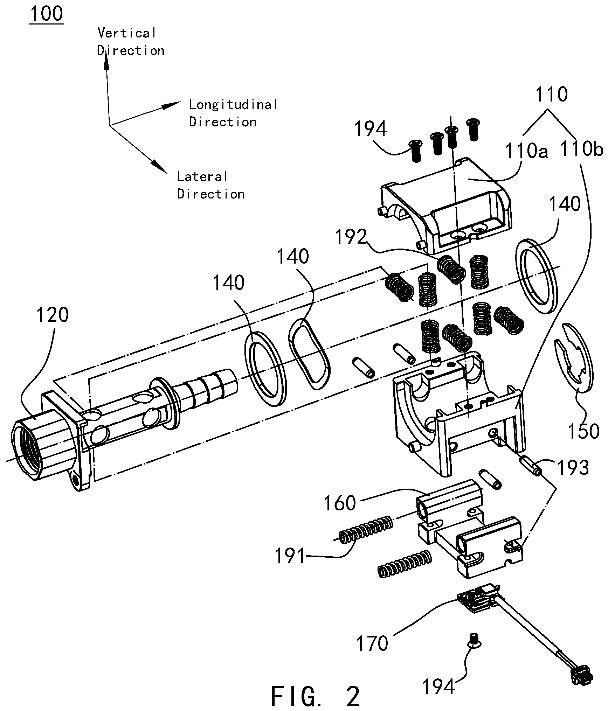

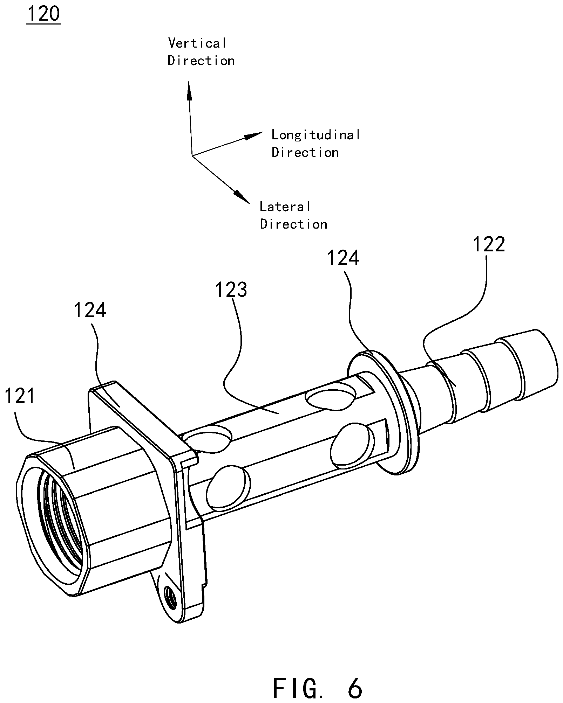

Returning to FIG. 2, the pipe 120 is disposed in the housing 110, and the second floating spring 192 is disposed between the pipe 120 and the housing 110 to realize a lateral floating, a vertical floating and a tilting floating. The tilting floating refers to that the pipe 120 is tilted in the lateral direction, tilted in the vertical direction, or tilted in both the lateral direction and the vertical direction. For example, a first end 121 of the pipe 120 may be slightly lower or higher than a second end 122 thereof (see FIG. 6), so as to flexibly adapt to a tolerance between the first item and the second item. In this embodiment, a plurality of second floating springs 192 are disposed around the pipe 120, so that the pipe 120 is floatable relative to the housing 110 in the lateral direction, in the vertical direction, and in a tilting manner.

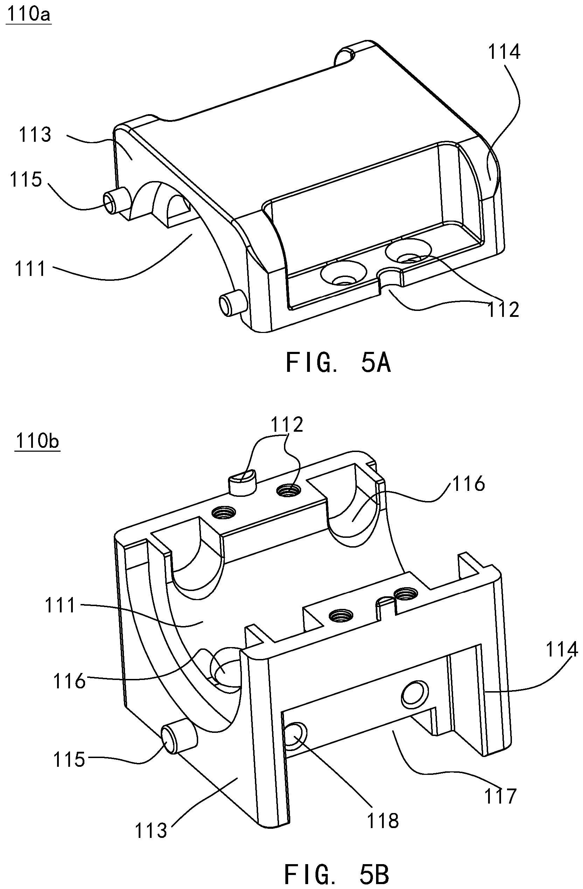

A specific structure of the housing 110 is described with reference to FIGS. 5A to 5B. In this embodiment, the housing 110 is assembled by a first housing 110a and a second housing 110b through bolts 194, which is convenient for processing and manufacturing. In other embodiments, the housing 110 may be integrally formed.

Each of the first housing 110a and the second housing 110b has a semi-cylindrical accommodation space 111, so that the first housing 110a and the second housing 110b may be assembled with each other to form a complete accommodation space 111. The first housing 110a and the second housing 110b may respectively have a plurality of bonding portions 112, such as engaging portions, bolt holes and the like, so that they are assembled with each other, or assembled by other conventional bonding methods in the art, so as to form a complete housing 110. In addition, since a method for dividing the housing 110 into the first housing 110a and the second housing 110b may be changed, for example, the housing may be divided vertically, laterally or obliquely, any structural features of the housing 110 as described in the present disclosure may be provided on any one of the first housing 110a and the second housing 110b.

An outer surface of the housing 110 is substantially square, and has a first end wall 113 and a second end wall 114 which are opposite to each other along the longitudinal direction. The accommodation space 111 has a cylindrical shape extending along the longitudinal direction. However, the present disclosure is not limited thereto. In other embodiments, the outer surface of the housing 110 may be cylindrical, hexagonal, etc., and the accommodation space 111 may be square, hexagonal, etc. An outer side surface of the first end wall 113 is provided with a plurality of limit portions 115 extending along the longitudinal direction to limit a horizontal floating range, a vertical floating range and a tilting floating range of the pipe 120 relative to the housing 110. For example, the limit portion 115 may abut against and be sleeved around the gasket 140, and the gasket 140 is sleeved outside the pipe 120. Therefore, the limit portion 115 may limit the lateral floating range, the vertical floating range and the tilting floating range of the pipe 120.

An inner wall of the housing 110 (i.e., an outer side surface of the accommodation space 111) is provided with a plurality of second spring slots 116. Each of the second spring slots 116 is recessed into the housing 110 in a lateral or vertical direction to accommodate the second floating springs 192, respectively.

In other embodiments, the second floating spring 192 may be provided in different forms, such as a flexible substance or liquid filled in the housing 110.

The outer surface of the housing 110 is provided with a recessed portion 117, and the base 160 is disposed in the recessed portion 117. Specifically, the recessed portion 117 is provided to be recessed into the housing 110 in the lateral and vertical directions, and extends between the first end wall 113 and the second end wall 114 in the longitudinal direction. Thus, the recessed portion 117 forms a slot that may accommodate the base 160 and allow the housing 110 to slide in the longitudinal direction relative to the base 160. The housing 110 is also provided with a plurality of holes 118, which are, for example, provided on a side wall of the recessed portion 117. Combination with FIG. 2, a plurality of pins 193 are inserted into the holes 118 to be fixed to the housing 110. These pins 193 are inserted into sliding grooves 163 of the base to guide the longitudinal sliding of the housing 110 relative to the base 160.

The specific structure of the pipe 120 will be described with reference to FIG. 6.

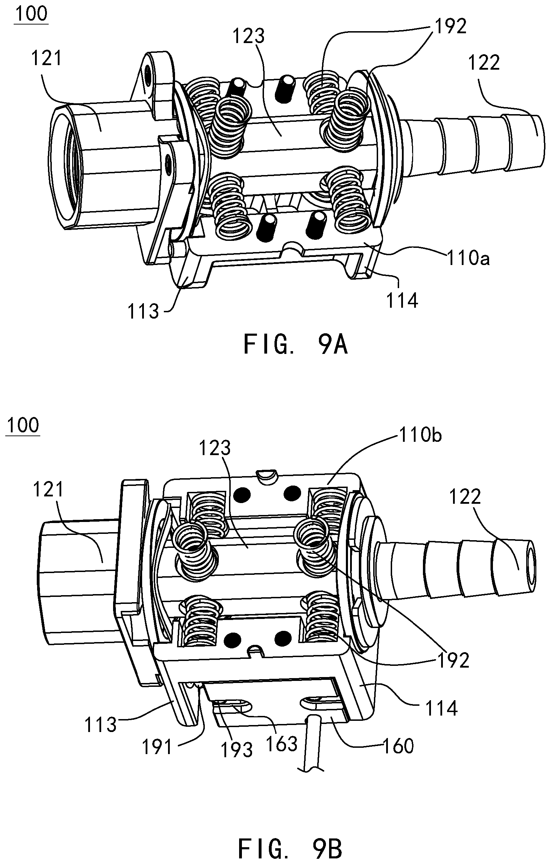

The pipe 120 includes a first end 121, a second end 122, and an intermediate section 123 connected between the first end 121 and the second end 122. Both the first end 121 and the second end 122 are located outside the housing 110, and the intermediate section 123 is located inside the housing 110. A first flange 124 is provided between the first end 121 and the intermediate section 123, and a second flange 125 is provided between the second end 122 and the intermediate section 123. The first flange 124 and the second flange 125 are located outside two ends of the housing 110 in the longitudinal direction. Referring to FIG. 9B in combination, a gasket 140 is provided between the first flange 124 and the first sidewall 113 of the housing, and a gasket 140 and a clamping ring 150 are provided between the second flange 125 and the second sidewall 114 of the housing 110. Thus, the pipe 120 is substantially prevented from moving along the longitudinal direction relative to the housing 110, so that the pipe 120 and the housing 110 float along the longitudinal direction together. Further referring to FIG. 1F, the first flange 124 may be provided with at least one alignment portion 124a, for example, an alignment portion 124a in a form of a threaded hole is provided on a side of the first flange 124 facing away from the housing 110. The alignment portion 124a may be connected to a guide rod (not shown) to facilitate the alignment of the pipe 120 with the second item.

During use, the first end 121 of the pipe 120 is connected to a joint (not shown) of the second item, and the second end 122 is connected to a fluid pipe (not shown), thereby introducing a fluid such as a cooling fluid into the second item. The connection between the first end 121 and the second item may be implemented by being inserted along the longitudinal direction. The connector 100 of the present disclosure provides a longitudinal pressure feedback function to ensure a stable connection, wherein the stable connection means that a longitudinal pressure between the first end 121 and the second item exceeds a threshold. That is, when there is no connection between the first end 121 and the second item, or the longitudinal pressure between the first end 121 and the second item does not exceed the threshold, the housing 110 (and the pipe 120) is located in the second floating position, thus indicating that there is no stable connection. When the longitudinal pressure between the first end 121 and the second item exceeds the threshold, the housing 110 (and the pipe 120) floats longitudinally relative to the base 160 and leaves the second floating position, thus indicating a stable connection. In this way, a biasing force of the first floating spring 191 may be set according to the pressure threshold, for example, it is set to be approximately equal to the pressure threshold, so that when the longitudinal pressure between the first end 121 of the pipe 120 and the second item exceeds the pressure threshold, the pipe 120 and the housing 110 can leave the second floating position against the biasing force of the first floating spring 191 under the action of the longitudinal pressure.

When the pipe 120 and the housing 110 leave the second floating position, the indicator 170 may provide an indication signal to indicate that the longitudinal pressure exceeds the threshold. The indicator 170 will be described in detail below.

In other embodiments, the second end 122 of the pipe 120 is connected to the second item, and the first end 121 is connected to the fluid pipe. Alternatively, in other embodiments, the first end 121 and the second end 122 of the pipe 120 are respectively connected to a joint of the second item and a joint of a third item, and the third item is a bracket or a plate fixed to the first item or the second item. Thus, the connector 100 can adapt to the tolerances among the first item, the second item and the third item.

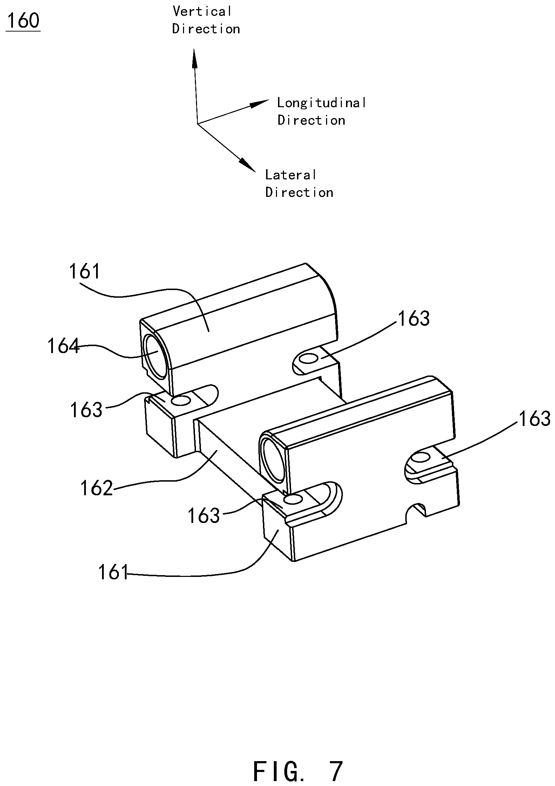

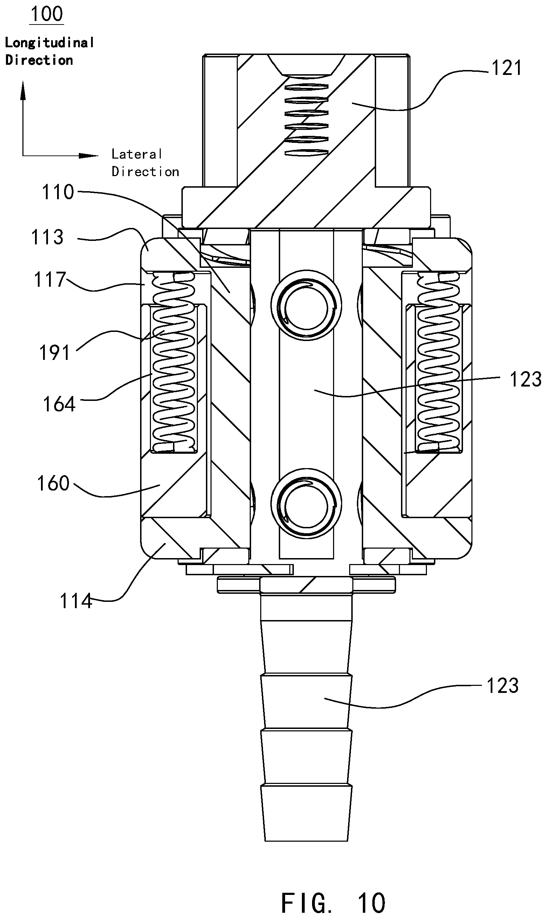

The specific structure of the base 160 will be described with reference to FIG. 7. The base 160 includes a pair of sliding portions 161 and a bridge portion 162 connected between the sliding portions 161. The sliding portions 161 are substantially rectangular, and each of the sliding portions 161 is provided with a first spring slot 164 for accommodating the first floating spring 191. The first spring slot 164 extends along the longitudinal direction. One end of the first spring slot 164 is opened at an outer side surface of the sliding portion 161, and the other end thereof is closed in the sliding portion 161, so that the first spring slot 164 is formed in a form of a blind hole. Referring to FIG. 10, one end of the first floating spring 191 extends to the outside of the sliding portion 161 and abuts against the first end wall 113 of the housing 110, and the other end thereof abuts against the first spring slot 164.

Each of the sliding portions 161 is provided with a sliding groove 163 extending along the longitudinal direction. As described above, the pin 193 fixed to the housing 110 is inserted into the sliding groove 163 to guide the longitudinal floating of the housing 110 relative to the sliding portion 161. In this embodiment, each of the sliding portions 161 is provided with two sliding grooves 163 which are opposite to each other along the longitudinal direction, and two pins 193 are respectively inserted into the two sliding grooves 163, thus guiding the longitudinal floating of the housing 110 more stably.

Referring to FIG. 2, the sliding portions 161 are disposed on both sides of the housing 110 along the lateral direction, and the bridge portions 163 are disposed on a bottom side of the housing 110. Neither the sliding portion 161 nor the bridge portion 162 extends beyond the extension range of the housing 110 on the plane perpendicular to the longitudinal direction. In this embodiment, the two sliding portions 161 and the bridge portion 163 of the base 160 form a frame surrounded by three sides, and are embedded into a concave portion 117 of the housing 110 having a corresponding shape (that is, a shape of the concave portion 117 is a concave portion surrounded by three sides), so that a gap between the square outer surface of the housing 110 and the cylindrical accommodation space 111 is effectively utilized. In other embodiments, the base 160 may have different shapes, for example, in a shape of a flat plate as a whole, as long as it can be fixed to the first item and allow the housing 110 to float longitudinally relative to the base 160.

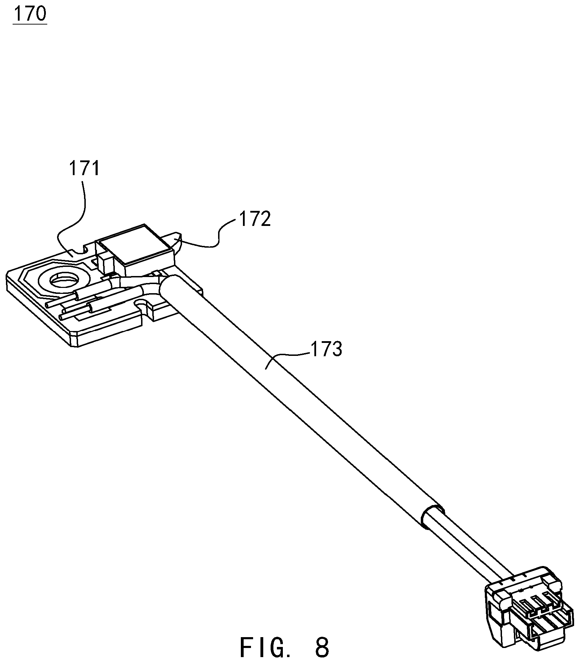

The indicator 170 is described with reference to FIG. 8.

Generally, the indicator 170 is disposed on the base 160 and is configured to send a signal when the housing 110 is disengaged from the second longitudinal position. As mentioned above, when the pipe 120 is not connected to the second item, or the pipe 120 is connected to the second item but does not generate a longitudinal pressure exceeding the threshold, the housing 110 is in the second longitudinal position. Thus, when the housing 110 is disengaged from the second longitudinal position, it means that the longitudinal pressure exceeding the threshold has been generated between the housing 110 (and the pipe 120) and the second item. That is, the indicator 170 functions to indicate that the housing 110 has generated a considerable longitudinal floating, which also indicates that the pipe 120 has been stably connected to the second item.

Specifically, the indicator 170 includes a plate portion 171, a switch 172, and a signal line 173. The plate portion 171 has a square plate shape and is accommodated in the bridge portion 162 of the base portion 160. More specifically, the plate portion 171 is embedded in a side surface of the bridge portion 162 facing away from the housing 110 to reduce the overall volume of the connector 100.

The switch 172 may be switched between a non-triggered state and a triggered state, and may be provided to send an indication signal when it is in the non-triggered state. For example, in the triggered state, the switch 172 retracts into the plate portion 171, and in the non-triggered state, the switch 172 extends from the plate portion 171 and sends the indication signal. When the housing 110 is in the second longitudinal position, the second end wall 114 of the housing 110 abuts against the switch 172 to keep the switch 172 in the triggered state. More specifically, referring to FIG. 3B, the housing 110 is in the first longitudinal position, that is, disengaged from the second longitudinal position, and at this time, the switch 172 is in the non-triggered state and extends from the plate portion 171 towards the second end wall 114. For example, a spring (not shown) is provided in the plate portion 171 to bias the switch 172 towards the extending direction. At this time, the indicator 170 outputs the indication signal through the signal line 173 to indicate that the housing 110 has been disengaged from the second longitudinal position, that is, the longitudinal pressure exceeding the threshold has been generated.

Referring to FIG. 4B, at this time, the housing 110 is in the second longitudinal position, and the second end wall 114 abuts against the base 160, so that the switch 172 of the indicator 170 is in the triggered state, that is, retracted into the plate portion 171. Thus, the indicator 170 does not send the indication signal.

It should be understood that when the housing 110 is disengaged from the second longitudinal position by a certain distance (which may be referred to as "switch stroke"), the switch 172 may extend from the plate portion 171. The switch stroke may be smaller than the distance between the first longitudinal position and the second longitudinal position. Thus, when the distance between the second end wall 114 of the housing 110 and the base 160 exceeds the switch stroke, the switch 172 is switched from the triggered state to the non-triggered state and sends the indication signal. When the first end wall 113 of the housing 110 functions to limit a range of longitudinal movement of the housing 110 relative to the base 160.

In addition, in a process of establishing the connection between the second end 121 of the pipe 120 and the second item as mentioned above, the housing 110 is disengaged from the second longitudinal position to show that the longitudinal pressure between the housing 110 and the second item has exceeded the threshold. After the connection between the second end 121 and the second item is established, depending on the type of connection, the housing 110 may be kept to be disengaged from the second longitudinal position or return to the second longitudinal position under the action of the first floating spring 191. For example, the second end 121 is inserted into the second item by friction fit, and after the connection is established, the second end 121 and the second item may move relative to each other, thereby allowing the housing to return to the second longitudinal position.

The plate portion 171 is provided with a slot, so that the signal line 173 extends from the switch 172 to the outside. In other embodiments, the indication signal may be sent wirelessly, that is, the signal line 173 may be omitted.

The specific structure of the indicator 170 in this embodiment may advantageously reduce the overall size of the connector 100 and transmit electrical signals that are easily received. In other embodiments, the indicator 170 may have different structures as long as it may transmit signals according to the change of position between the base 160 and the housing 110.

Referring to FIGS. 9A and 9B, the relationships among components of the connector 100 of the present disclosure, especially the positional relationships among the housing 110, the pipe 120 and the second floating spring 192 are shown.

Referring to FIG. 10, the relationships among the components of the connector 100 of the present disclosure, especially the positional relationships among the base 160, the housing 110 and the first floating spring 191 are shown.

Although preferred embodiments have been shown and described herein, it should be understood that these embodiments are given by way of example only. Various variations, changes and substitutions will be made by those skilled in the art without departing from the spirit of the present disclosure. Therefore, the appended claims are intended to cover all such modifications that fall within the spirit and scope of the present disclosure.

## Claims

1. A connector (100) comprising: a housing (110); a pipe (120) at least partially disposed in the housing (110); and a base (160) mounted to a first item and disposed to the housing (110) to allow the housing (110) to float between a first longitudinal position and a second longitudinal position relative to the base (160), such that the pipe (120) is connected to a second item in a floating manner along the longitudinal direction.

2. The connector (100) according to claim 1, wherein the connector (100) further comprises an indicator (170) provided on the base (160) and configured to send an indication signal when the housing (110) is disengaged from the second longitudinal position.

3. The connector (100) according to claim 2, wherein
the indicator (170) comprises a switch (172),
wherein when the housing (110) is in the second longitudinal position, the switch (172) is in a triggered state, such that the switch (172) does not send the indication signal; and
when the housing (110) is disengaged from the second longitudinal position, the switch (172) is in a non-triggered state and sends the indication signal.

4. The connector (100) according to claim 3, wherein the indicator (170) further comprises a plate portion (171) disposed in the base (160);
when the switch (172) is in the triggered state, the switch (172) abuts against the housing (110) and retracts into the plate portion (171), and when the switch (172) is in the non-triggered state, the switch (172) extends from the plate portion (171).

5. The connector (100) according to claim 1, wherein the connector (100) further comprises a first floating spring (191) disposed between the base (160) and the housing (110), and biasing the housing (110) towards the second longitudinal position relative to the base (160).

6. The connector (100) according to claim 5, wherein an outer surface of the housing (110) is provided with a recessed portion (117), and the housing (110) is provided with a first end wall (113) and a second end wall (114) that are opposite to each other along the longitudinal direction;
the base (160) is disposed in the recessed portion (117), and the first end wall (113) and the second end wall (114) respectively abut against the base (160) to define the first longitudinal position and second longitudinal position of the housing (110).

7. The connector (100) according to claim 6, wherein the base (160) comprises at least one sliding portion (161) provided in the recessed portion (117), and each of the at least one sliding part (161) is provided with a first spring slot (164) for accommodating the first floating spring (191);
one end of the first floating spring (191) abuts against the first end wall (113), and the other end of the first floating spring (191) abuts in the first spring slot (164).

8. The connector (100) according to claim 7, wherein each of the at least one sliding portion (161) is provided with at least one sliding groove (163) extending along the longitudinal direction; and
the connector (100) comprises at least one pin (193) fixed to the housing (100). the pin (193) extends laterally and is inserted into the sliding groove (163) to guide a longitudinal movement of the housing (110).

9. The connector (100) according to claim 7, wherein the base (160) comprises:
a pair of sliding portions (161) laterally disposed on both sides of the housing (110); and
a bridge portion (162) connected between the sliding portions (161); and
the sliding portions (161) and the bridge portion (162) do not exceed an extension range of the housing (110) on a plane perpendicular to the longitudinal direction.

10. The connector (100) according to claim 1, wherein
the housing (110) comprises an accommodation space (111) extending along the longitudinal direction, and the pipe (120) is accommodated in the accommodation space (111) and is floatable relative to the housing (110) along a lateral direction and a vertical direction.

11. The connector (100) according to claim 10, wherein the connector (100) further comprises a plurality of second floating springs (192) arranged between an inner wall of the housing (110) and an outer wall of the pipe (120) along the lateral direction and the vertical direction, so as to allow a lateral floating, a vertical floating, or a tilting floating of the pipe (120).

12. The connector (100) according to claim 10, wherein
the base (160) is provided outside the accommodation space (111).
